# EUROPÄISCHE PATENTANMELDUNG

(11) **EP 1 118 999 A1**
(43) Veröffentlichungstag der Anmeldung: **25.07.2001**
(21) Anmeldenummer: 00128665.7
(22) Anmeldetag: 28.12.2000
(51) Int. Cl.: G11C 7/00, G11C 11/409

(54) **Verfahren und Vorrichtung zum wechselweisen Betreiben eines Schreib-Lese-Speichers im Ein-Speicher-Betriebsmodus und im verschränkten Mehr-Speicher-Betriebsmodus**

(30) Priorität: 19.01.2000 DE 10002130
(71) Anmelder: Infineon Technologies AG, 81669 München (DE)
(72) Erfinder: Polney, Jens, 81539 München (DE)
(74) Vertreter: Fischer, Volker, Dipl.-Ing.

(57) **Zusammenfassung**

Verfahren und Vorrichtung zum wechselweisen Betreiben eines Schreib-Lese-Speichers im Ein-Speicher-Betriebsmodus und im verschränkten Mehr-Speicher-Betriebsmodus

In einem Schreib-Lese-Speicher wird auf Steuerleitungen, die die Steuerlogik mit jeder Speicherzelle eines Zellenfeldes verbinden, eine Folge von Auswahlsignalen für eine verschränkte Mehr-Speicher-Betriebsfunktionalität, wenn sich der Speicher in einem verschränkten Mehr-Speicher-Betriebsmodus befindet, und eine Folge von Auswahlsignalen für die Schreib-Freigabefunktionalität, wenn sich der Speicher in einem Ein-Speicher-Betriebsmodus befindet, geliefert.

## Beschreibung

Die Erfindung betrifft ein Verfahren zum wechselweisen Betreiben eines Schreib-Lese-Speichers im Ein-Speicher-Betriebsmodus und im verschränkten Mehr-Speicher-Betriebsmodus und einen entsprechend ausgelegten Schreib-Lese-Speicher.

Ein Schreib-Lese-Speicher (RAM) ist ein Speicher, in dem nach Vorgabe einer Adresse Daten abgespeichert und unter dieser Adresse wieder ausgelesen werden können. Die Speicherzellen des RAMs sind dabei in Form einer Matrix angeordnet, wobei zur Auswahl einer bestimmten Speicherzelle eine Adresse von einem Spalten- bzw. Zeilendecoder festgelegt wird. Unter dieser Adresse kann dann ein aus mehreren Bits bestehendes Wort abgespeichert werden.

So sind von der Firma Rambus unter der Bezeichnung "Direct RDRAM" 256/288-Mbit-DRAMs bekannt, die eine Wortbreite von 16 oder 18 Bits aufgebaut sind. Diese DRAMs ermöglichen hohe Signalgeschwindigkeiten mit Übertragungsraten bis 800 MHz. Die DRAMs bestehen dabei aus zwei Hauptblöcken, einem Kernblock, der Speicherbänke und Schreib-Lese-Verstärker umfasst, und einem Schnittstellenblock, der einer externen Steuereinrichtung ermöglicht, auf den Kernblock mit einer Geschwindigkeit bis zu 1,6 GB/s zuzugreifen. Der 32 Mbyte Kernblock des RDRAMs ist in 32 Ein-Mbyte-Speicherbänke eingeteilt, die jeweils in 512 Reihen organisiert sind. Jede Reihe enthält 128 Speichereinheiten, die jeweils 16 Bytes enthalten. Diese Speichereinheiten sind die kleinsten Dateneinheiten des RDRAMs, die adressiert werden können. Der Schnittstellenblock enthält eine Logik zum Verarbeiten und Weiterleiten von Signalen an den Kernblock des RDRAM und ist über einen Hochgeschwindigkeitsbus mit der Steuereinrichtung verbunden, wobei der RDRAM über 18 Daten-Pins an den Bus angeschlossen ist. Die 18 Daten-Pins dienen dabei zum Lesen und Schreiben von Daten über den Bus in den Kernblock und werden auf zwei 32- bzw. 36-Bit-Datenleitungen, die innerhalb des RDRAMS mit einem 1/8 der Datenfrequenz betrieben werden, gemultiplext. Eine Reihe weiterer Steuer-Pins, die den Schnittstellenblock an den Bus anschließen, dient dazu, der Steuereinrichtung Zugang zu Steuerregistern zu ermöglichen, die Informationen über die RDRAM-Konfiguration enthalten und den Betriebsmodus des Speichers festlegen. Außerdem ist in den Steuerregistern die Adresse des RDRAM für die Steuereinrichtung eingespeichert. Am Schnittstellenblock sind weiterhin Adressen-Pins vorgesehen, die den Spalten- bzw. Zeilenzugriff auf die Speicherzellen im RDRAM steuern. Die US 5 513 327 beschreibt Grundzüge des Rambus-Konzepts.

Die RDRAMs werden in Gruppen von acht Speichereinheiten über den Hochgeschwindigkeitsbus von der Steuereinrichtung betrieben, wobei zwei verschiedene Betriebsmodi vorgesehen sind. Im Ein-Speicher-Betriebsmodus antwortet jeweils immer nur ein DRAM am Bus auf einen Befehl der Steuereinrichtung. Über die Adressen-Pins werden dabei Spalten- und Zeilen-Adressensignale an den jeweiligen RDRAM geliefert. Über die 18 Daten-Pins erfolgt dann ein Datentransfer in und aus dem Kernblock des jeweiligen RDRAMs. Der Schnittstellenblock liefert an den Kernblock einen Spaltenzugriffimpuls CAS und einen Zeilenzugriffimpuls RAS, die die Zeitbedingungen für den Spalten- bzw. Zeilenzugriff festlegen, sowie ein Schreib-Lese-Signal, das bestimmt, ob eine Schreib- oder eine Leseoperation durchgeführt werden soll. Weiterhin ist eine Schreib-Freigabefunktionalität (WE-Funktionalität) im Ein-Speicher-Betriebsmodus vorgesehen, wobei der Schnittstellenblock über 16 WE-Steuerleitungen parallel zu den 18 Datenleitungen mit dem Kernblock verbunden ist, um Signale an den Kernblock auszugeben, die festlegen, ob beim Schreiben in den Kernblock ein bestimmtes Bit eines Datenpakets zu maskieren und damit nicht in das Zellenfeld zu schreiben ist.

Neben dem Ein-Speicher-Betriebsmodus können die RDRAMs auch in verschränkten Mehr-Speicher-Betriebsmodus betrieben werden. In diesem Betriebsmodus ist es möglich, dass die über den gemeinsamen Bus von der Steuereinrichtung betriebenen RDRAMs ineinander verschachtelte Datenpakete auf den Bus ausgeben bzw. vom Bus empfangen. Der verschachtelte Mehr-Speicher-Betriebsmodus ermöglicht es, dass eine Gruppe von acht DRAMs am Bus gemeinsam auf einen Befehl der Steuereinheit antwortet. Ziel des verschachtelten Mehr-Speicher-Betriebsmodus ist es dabei, die Anzahl der Bits in einem Datenpaket, die von einem einzelnen DRAM ausgelesen bzw. in ihn hineingeschrieben werden, zu begrenzen. Im verschachtelten Mehr-Speicher-Betriebsmodus besteht ein 16- bzw. 18-Bit langes Datenpaket, das auf den Bus ausgegeben bzw. vom Bus empfangen wird, aus jeweils zwei bzw. drei Bits der acht angesteuerten DRAMs. Diese Auslegung hat den Vorteil, dass, wenn aufeinanderfolgende Bits in einem Datenpaket gestört sind, dieser Fehler, der normalerweise nicht korrigierbar ist, durch Entschachteln des Datenwortes beim Empfang in jeweils nur ein falsches Bit pro DRAM aufgeteilt wird. Dieser 1-Bit-Fehler kann von der Steuereinrichtung dann mit Hilfe einer Fehler-Korrektur-Software berichtigt werden.

Der verschränkte Mehr-Speicher-Betriebsmodus (IDM-Modus) wird in den RDRAMs der Firma Rambus dadurch implementiert, dass vom Schnittstellenblock zum Kernblock die zusätzlichen 8 IDM-Steuerleitungen vorgesehen sind, mit denen die 18 Daten-Pins zum Lesen und Schreiben eines Datenwortes in bzw. aus dem Kernblock einzeln angesteuert werden können. Die Pin-Aus-wahl wird dabei mittels eines IDM-Decoders ausgeführt, der vom Schnittstellenblock ein 1-Bit-IDM-Statussignal enthält, das festlegt, ob der DRAM sich im Ein-Speicher-Betriebsmodus oder im verschränkten Mehr-Speicher-Betriebsmodus befindet, und ein 3-Bit-Auswahlsignal, das die Pins zum Ein- und Ausgeben von Daten in den Kernblock bestimmt. Wenn das IDM-Statussignal dem IDM-Decoder den verschränkten Mehr-Speicher-Betriebsmodus anzeigt, decodiert dieser das 3-Bit-IDM-Auswahlsignal, um über zwei bzw. drei Pins der 18 Datenleitungen in den Kernblock zu schreiben bzw. aus dem Kernblock auszulesen. Während der Schreiboperation werden dabei alle Pins maskiert, außer den von dem IDM-Decoder bestimmten Pins. Während der Leseoperation werden Daten aus dem Kernblock auf den zwei oder drei Pins, die aus dem IDM-Auswahlsignal decodiert sind, übertragen, während die restlichen Pins auf eine logische Null gesetzt werden.

Nachteilhaft bei der von der Firma Rambus implementierten verschränkten Mehr-Speicher-Betriebsfunktionalität ist der hohe Raumbedarf der zusätzlichen IDM-Steuerleitungen und des IDM-Decoder auf dem DRAM-Chip.

Aufgabe der vorliegenden Erfindung ist es deshalb, einen Schreib-Lese-Speicher so weiterzubilden, dass er wechselweise im Ein-Speicher-Betriebsmodus und im verschränkten Mehr-Speicher-Betriebsmodus mit einem minimalen Raumbedarf der Steuerelemente auf dem Chip betrieben werden kann.

Diese Aufgabe wird durch ein Verfahren gemäß Anspruch 1 und einen Schreib-Lese-Speicher gemäß Anspruch 5 gelöst. Bevorzugte Weiterbildungen sind den abhängigen Ansprüchen angegeben.

Gemäß der Erfindung wird in einem Schreib-Lese-Speicher zum wechselweisen Betreiben im Ein-Speicher-Betriebsmodus und im verschränkten Mehr-Speicher-Betriebsmodus auf Steuerleitungen, die eine Steuerlogik mit jeweils einer Speicherzelle des Schreib-Lese-Speichers verbinden, eine Folge von Auswahlsignalen für eine verschränkte Mehr-Speicher-Betriebsfunktionalität, wenn ein Betriebsmodussignal den verschränkten Mehr-Speicher-Betriebsmodus anzeigt, und eine Folge von Maskierungssignalen für die Schreib-Freigabefunktionalität, wenn das Betriebsmodussignal den Ein-Speicher-Betriebsmodus anzeigt, geliefert.

Mit der erfindungsgemäßen Auslegung ist es möglich, ein und dieselben Steuerleitungen zum Ansteuern sowohl der Schreib-Freigabefunktionalität im Ein-Speicher-Betriebsmodus, bei der während des Schreibens in den Schreib-Lese-Speicher bestimmte Bits eines Datenwortes maskiert und nicht in das Zellenfeld geschrieben werden können, und zur Ansteuerung der verschränkten Mehr-Speicher-Betriebsfunktionalität, bei der bestimmte Bits eines Datenwortes ausmaskiert werden, um ein verschränktes Datenwort mit weiteren Schreib-Lese-Speichern erzeugen zu können, zu nutzen. Dies ist deshalb möglich, weil während der verschränkten Mehr-Speicher-Betriebsfunktionalität des Schreib-Lese-Speichers eine gleichzeitige Verwendung der Schreib-Freigabefunktionalität nicht erlaubt ist. Es besteht so die Möglichkeit, die Signale der beiden Modi miteinander zu multiplexen, so dass nur ein Satz Steuerleitungen erforderlich ist, wodurch eine Einsparung von Chipfläche erreicht wird. Gegenüber dem von der Firma Rambus verwendeten DRAMs kann so durch Verwendung der bereits vorhandenen WE-Steuerleitungen der Schreib-Freigabefunktionalität eine Einsparung der IDM-Steuerleitungen zur verschränkten Mehr-Speicher-Betriebsfunktionalität sowie der zugehörige IDM-Decoder erreicht werden.

Die Erfindung wird anhand der Zeichnungen näher erläutert. Es zeigen:
- Figur 1: ein Computersystem, bei dem die erfindungsgemäßen DRAMs verwendet werden;
- Figur 2: ein Block-Diagramm eines erfindungsgemäßen DRAMs;
- Figur 3: die Verbindung des Speicherbereiches mit dem Schnittstellenblock beim erfindungsgemäßen DRAM; und
- Figur 4: das erfindungsgemäße Multiplexen der Schreib-Freigabefunktionalität und der verschränkten Mehr-Speicher-Betriebsfunktionalität bei dem DRAM.

Im Folgenden wird die Erfindung anhand eines dynamischen Schreib-Lese-Speicher (DRAM) dargestellt. Die Erfindung kann jedoch auch bei anderen Schreib-Lese-Speichern eingesetzt werden.

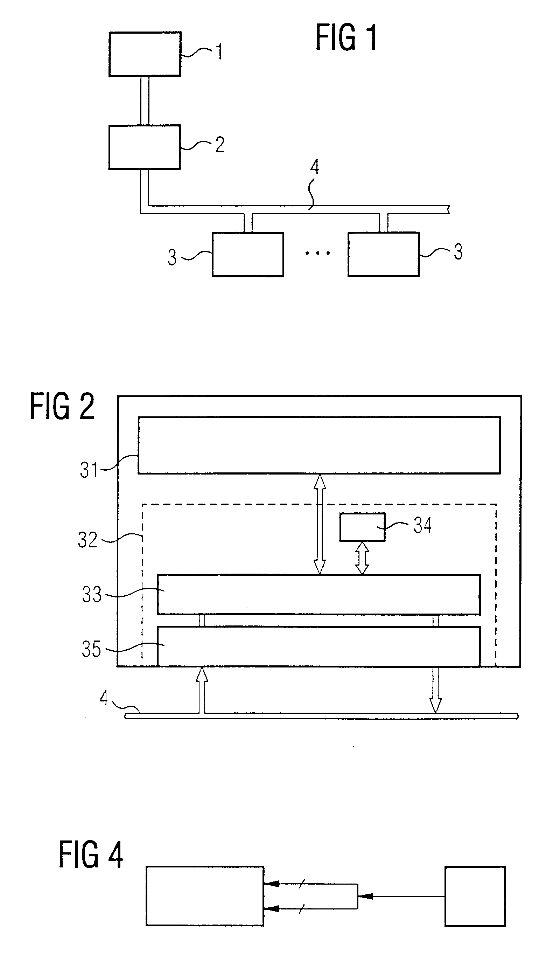

Figur 1 zeigt ein Computersystem, das eine Zentralverarbeitungseinheit 1, eine DRAM-Steuereinheit 2 und mehrere DRAMs 3 aufweist. Die Zentralverarbeitungseinheit 1 gibt Befehle an die DRAM-Steuereinheit 2 aus. Die DRAM-Steuereinheit 2 wiederum tauscht mit den DRAMs 3 Daten über den Hochgeschwindigkeitsbus 4 aus.

Figur 2 zeigt ein Block-Diagramm der in Figur 1 gezeigten DRAMs. Der DRAM 3 enthält eine Matrix 31 von Speicherzellen, die bankweise organisiert sind. Weiterhin ist ein Schnittstellenblock 32 vorgesehen, der eine Steuerlogik 33 zum Verarbeiten und Weiterleiten von Signalen zu und von der Speichermatrix 31 umfasst. Der Schnittstellenblock 32 enthält wiederum Steuerregister 34, die Steuerinformationen aus der DRAM-Steuereinheit 2, die den Betrieb des DRAMs 3 lenken, speichern. Der Schnittstellenblock 32 ist über Schnittstellen-Pins 35 mit dem Bus 4 verbunden, wobei die Anzahl der Pins von der Datenbreite des Busses 4 und vom Busprotokoll abhängt, das vom Computersystem, an das der DRAM angeschlossen ist, genutzt wird.

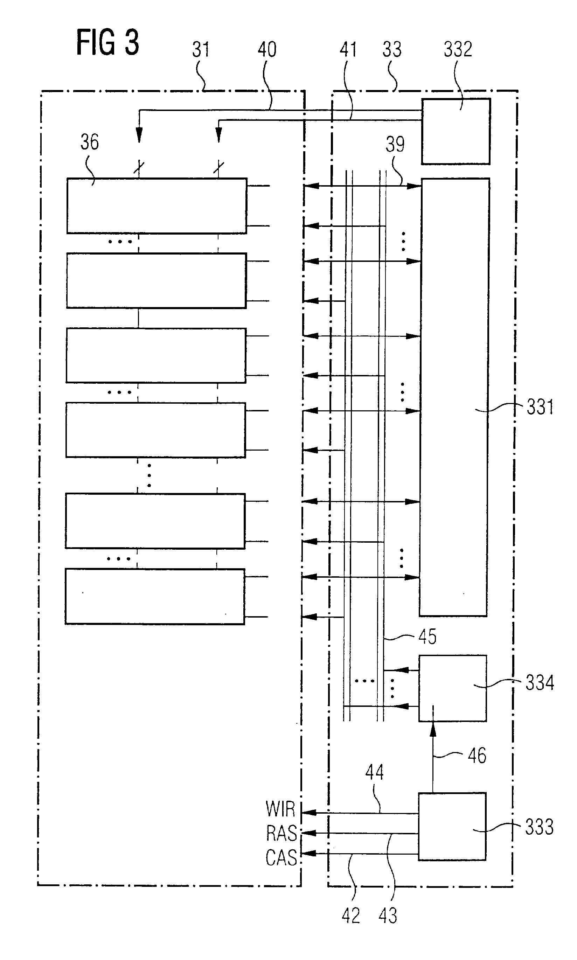

Figur 3 zeigt den Datenaustausch zwischen den Speicherbänken 36 der Speichermatrix 31 und der Steuerlogik 33 des Schnittstellenblocks 32. Die Speicherbänke 36 der Speichermatrix 31 sind in Dateneinheiten unterteilt, die einzeln adressiert werden können. Gemäß einer bevorzugten Ausführungsform ist der DRAM in 32 1-Mbyte Speicherbänke unterteilt, die jeweils 512 Reihen enthalten, wobei jede Reihe wiederum 128 Dateneinheiten enthält, die jeweils 16 Byte groß sind. Die Speicherbänke 36 werden über Schreib-Lese-Verstärker (nicht gezeigt) angesteuert, die wiederum an Datenleitungen 39 angeschlossen werden. In der gezeigten Ausführungsform wird der Datentransfer dabei vorzugsweise über 16 oder 18 Datenleitungen 39 zwischen den Speicherbänken 36 und einer Datenaustauscheinheit 331 der Steuerlogik 33 ausgeführt. Die Adresse der jeweils anzusteuernden Dateneinheit in den Speicherbänken 36 wird dabei von einer Adresslogikeinheit 332 der Steuerlogik 33 über die beiden Adresssteuerleitungen 40, 41 für Spalten- und Zeilenadressen festgelegt. Eine Steuereinheit 333 der Steuerlogik 33 liefert über Steuerleitungen 42, 43, 44 einen Spaltenzugriffsimpuls CAS, einen Zeilenzugriffsimpuls RAS und ein Schreib-Lese-Signal W/R. CAS und RAS sind jeweils Zeitsignale, die einen Zeilen- bzw. Spaltenzugriff anzeigen. W/R legt fest, ob eine Schreib- oder eine Leseoperation ausgeführt wird.

Die Steuerlogik 33 weist weiterhin eine Multiplexeinheit 334 auf. Diese Multiplexeinheit 334 ist über Steuerleitungen 45 mit der Speichermatrix 31 verbunden. Die Anzahl dieser Steuerleitungen 45 entspricht dabei der Anzahl der Datenleitungen 39. Die Multiplexeinheit 334 wird von der Steuereinheit 333 mit einem Betriebsmodussignal 46 angesteuert. Dieses Betriebsmodussignal 46 ist vorzugsweise ein 1-Bit-Signal und legt fest, ob der DRAM sich im Ein-Speicher-Betriebsmodus oder im verschränkten Mehr-Speicher-Betriebsmodus befindet. Der Ein-Speicher-Betriebsmodus wird vorzugsweise durch eine logische Null, der verschränkte Mehr-Speicher-Betriebsmodus dagegen durch eine logische Eins angezeigt.

Im Ein-Speicher-Betriebsmodus wird jeder DRAM 3 am Bus 4 von der DRAM-Steuereinheit 2 getrennt angesteuert, wobei über Datenleitungen 39 dann immer ein vollständiges Datenwort aus der Speichermatrix 31 ausgelesen bzw. in sie eingeschrieben wird. Die Steuerleitungen 45 und die Multiplexeinheit 334 dienen im Ein-Speicher-Betriebsmodus dazu, eine Folge von Maskierungsbits auszugeben, die erlauben, während einer Schreiboperation in die Speichermatrix 31 bestimmte Bits eines Datenwortes zu maskieren, damit diese nicht in das Zellenfeld eingeschrieben werden.

Im verschränkten Mehr-Speicher-Betriebsmodus, der der Multiplexeinheit 334 dadurch signalisiert wird, dass das Betriebsmodussignal 46 auf eine logische Eins gesetzt ist, legt die Multiplexeinheit 334 dagegen auf den Steuerleitungen 45 jeweils eine Folge von Auswahlsignalen für eine verschränkte Mehr-Speicher-Betriebsfunktionalität an. Diese Auswahlsignale legen fest, auf welchen Pins der Datenleitung jeweils Daten in die Speichermatrix 31 eingeschrieben bzw. aus ihr ausgelesen werden. Dieser Auswahlvorgang ermöglicht es, eine bestimmte Anzahl von DRAMs 3, die an den Bus 4 angeschlossen sind, gleichzeitig über die DRAM-Steuereinheit 2 anzusprechen. Im verschränkten Mehr-Speicher-Betriebsmodus sind jedem der so als Gruppe angesteuerten DRAMs 3 nur einzelne Bits des auf den Bus 4 übertragenen Datenpakets zugeordnet. Hierdurch wird gewährleistet, dass, wenn mehrere aufeinanderfolgende Bits in einem über den Bus 4 übertragenen Datenpaket gestört sind, dieser Fehler nicht dazu führt, dass diese Bits alle einem einzelnen DRAM zuzuordnen sind und sich dann nicht mehr korrigieren lassen. Da im Mehr-Speicher-Betriebsmodus jedes Datenpaket auf dem Bus jeweils aus einzelnen Bits der gemeinsam angesteuerten DRAMs zusammengesetzt ist, kann, wenn aufeinanderfolgende Bits in einem Datenpaket gestört sind, dieser Fehler durch Entschachteln des Datenpakets in jeweils ein falsches Bit pro DRAM aufgeteilt werden, das sich dann mit Hilfe einer Korrektursoftware berichtigen lässt. Der verschränkte Mehr-Speicher-Betriebsmodus ermöglicht somit eine verbesserte Fehlerkorrektur.

In der verschränkten Mehr-Speicher-Betriebsfunktionalität ist eine Schreib-Freigabefunktionalität für die DRAMs 3 nicht erlaubt. Es ist deshalb mit dem erfindungsgemäßen Aufbau möglich ein und dieselben Steuerleitungen 45 zur Ansteuerung der DRAMs 3 mit Auswahlsignalen für den verschränkten Mehr-Speicher-Betrieb und zur Ansteuerung des DRAMs 3 mit Maskierungssignalen für die Schreib-Freigabefunktionalität im Ein-Speicher-Betriebsmodus zu nutzen. Es werden also zur Übertragung der Steuerbefehle die gleichen Steuersignalleitungen benutzt. Hierdurch wird eine wesentliche Reduzierung der für die beiden Funktionalitäten erforderlichen Chipfläche erreicht. Weiterhin kann auch auf ein Ausdecodieren der zu maskierenden Bits im verschränkten Mehr-Speicher-Betriebsmodus und damit auf das Vorsehen eines IDM-Decoders verzichtet werden.

Wie Figur 4 zeigt, können die für die jeweilige Funktionalität erforderlichen Maskierungssignale direkt auf die Steuerleitungen 45 gemultiplext werden.

In der dargestellten Ausführungsform wird der DRAM im verschränkten Mehr-Speicher-Betriebsmodus so betrieben, dass acht DRAMs gleichzeitig auf einen Befehl der Steuereinheit reagieren. Hierbei werden Daten über die Datenleitungen 39 in die Speichermatrix 31 der DRAMs 3 über zwei oder drei Pins ein- und ausgeschrieben, so dass sich ein vollständiges 16- oder 18-Bit-Datenwort ergibt. Dieser Vorgang wird dann wenigstens siebenmal wiederholt, so dass alle Pins der acht DRAMs einmal angesprochen werden und damit jeweils ein vollständiges Datenwort jedes einzelnen DRAMs ein- bzw. ausgelesen wird.

Die in der vorstehenden Beschreibung, der Zeichnung und den Ansprüchen offenbarten Merkmale der Erfindung können sowohl einzeln als auch in beliebiger Kombination für die Verwirklichung der Erfindung in ihren verschiedenen Ausgestaltungen von Bedeutung sein.

## Patentansprüche

1. Verfahren zum wechselweisen Betreiben eines Schreib-Lese-Speichers im Ein-Speicher-Betriebsmodus und im verschränkten Mehr-Speicher-Betriebsmodus mit den Verfahrensschritten
Liefern auf gleichen Steuerleitungen (45), die eine Steuerlogik (33) mit jeweils einer Speicherzelle eines Zellenfeldes (31) verbinden, eine Folge von Auswahlsignalen für eine verschränkte Mehr-Speicher-Betriebsfunktionalität, wenn ein Betriebsmodussignal (46) einen verschränkten Mehr-Speicher-Betriebsmodus anzeigt, und eine Folge von Maskierungssignalen für die Schreib-Freigabefunktionalität, wenn das Betriebsmodussignal (46) einen Ein-Speicher-Betriebsmodus anzeigt.

2. Verfahren nach Anspruch 1, wobei das Betriebsmodussignal (46) ein 1-Bit-Signal ist.

3. Verfahren nach Anspruch 1 oder 2, wobei die Auswahlsignale für die verschränkte Mehr-Speicher-Betriebsfunktionalität bestimmte Pins der Datenleitungen (39) zu den Speicherzellen ausmaskieren.

4. Verfahren gemäß einem der Ansprüche 1 bis 3, wobei die Maskierungssignale für die Schreib-Freigabefunktionalität bestimmte Pins der Datenleitung (39) zu den Speicherzellen ausmaskieren, damit auf diesen Pins gelieferte Bits nicht ins Zellenfeld geschrieben werden.

5. Schreib-Lese-Speicher mit
einem Zellenfeld (31),
einer Steuerlogik (33), und
Steuerleitungen (45), die die Steuerlogik (33) mit jeder Speicherzelle des Zellenfeldes (31) verbinden,
wobei die Steuerlogik (33) auf den Steuerleitungen (45) eine Folge von Auswahlsignalen für eine verschränkte Mehr-Speicher-Betriebsfunktionalität an die Speicherzellen liefert, wenn sich der Speicher in einem verschränkten Mehr-Speicher-Betriebsmodus befindet, und eine Folge von Maskierungssignalen für die Schreib-Freigabefunktionalität an die Speicherzelle liefert, wenn sich der Speicher in einem Ein-Speicher-Betriebsmodus befindet.

6. Schreib-Lese-Speicher gemäß Anspruch 5, mit einer Multiplexeinheit (334), die an die Steuerleitungen (45) angeschlossen ist, um je nach Betriebsmodussignal (46) die Folge von Auswahlsignalen für die verschränkte Mehr-Speicher-Betriebs-funktionalität und die Folge von Maskierungssignalen für die Schreib-Freigabefunktionalität auf die Steuerleitungen (45) auszugeben.
